# EUROPÄISCHE PATENTANMELDUNG

(11) **EP 1 204 306 A2**
(43) Veröffentlichungstag der Anmeldung: **08.05.2002**
(21) Anmeldenummer: 01126179.9
(22) Anmeldetag: 05.11.2001
(51) Int. Cl.: H05K 3/32, H05K 3/36, G06K 19/077

(54) **Verfahren und Anordnung zum Kontaktieren von auf Substratfolien angeordneten metallischen Kontaktflächen**

(30) Priorität: 06.11.2000 DE 10054886
(71) Anmelder: cubit electronics Gmbh, 99099 Erfurt (DE)
(72) Erfinder: Michalk, Manfred, Dr., 99096 Erfurt (DE)
(74) Vertreter: Liedtke, Klaus, Dr.

(57) **Zusammenfassung**

2.1 Der Erfindung liegt die Aufgabe zugrunde, ein Verfahren und eine Anordnung anzugeben, mit welchen metallische Kontaktflächen von Zwischenträgern produktiv und elektrisch und mechanisch zuverlässig mit elektrisch leitenden Kontaktflächen auf Substraten kontaktiert werden können.
2.2 Erfindungsgemäß gelingt die Lösung der Aufgabe dadurch, dass die Kontaktfelder eine Gitterstruktur aufweisen, die zu kontaktierenden Bereiche übereinander positioniert und mit einem lichtdurchlässigen Pressstück zusammengedrückt werden, und die zu kontaktierenden Bereiche mit Licht hoher Intensität eines Wellenlängenbereiches, für den das Pressstück und die thermoplastische Substratfolie durchlässig aber die Kontaktfelder und Kontaktflächen stark energieabsorbierend sind, so bestrahlt wird, dass die bestrahlten Kontaktmaterialien erhitzt werden und dadurch das anliegende und/oder angepresste Substrat in der Verbindungszone aufschmilzt.
2.3 Die Erfindung betrifft ein Verfahren und eine Anordnung zum Kontaktieren von auf Substratfolien angeordneten metallischen Kontaktflächen mit elektrisch leitenden Kontaktflächen, die sich auf Substraten aus Plaste, Papier, Pappe oder ähnlichem befinden.

## Beschreibung

Die Erfindung betrifft ein Verfahren und eine Anordnung zum Kontaktieren von auf Substratfolien angeordneten metallischen Kontaktflächen mit elektrisch leitenden Kontaktflächen, die sich auf Substraten aus Plaste, Papier, Pappe oder ähnlichem befinden.

Dabei werden unter elektrisch leitenden Kontaktflächen Metalle, Leitpastendrucke aus Metall- und/oder Graphitpartikeln sowie elektrisch leitende Kunststoffe verstanden.

Bevorzugtes Einsatzgebiet der Erfindung ist die Kontaktierung von Halbleiterchips, weitere elektronische Bauelemente sowie Sensoren und/oder Aktoren tragende mit Leiterbahnen und großflächigen äußeren Kontakten versehene Zwischenträger-Plastikfolienstreifen auf flächige oder drahtförmige Antennen für kontaktlose Transponder. Als kontaktlose Transponder werden dabei insbesondere kontaktlose Chipkarten, Waren oder Warenverpackungen mit eingearbeiteten Antennen und Transponderchip, elektronische kontaktlose Etiketten, Tickets, Wertscheine etc. verstanden.

Kontaktlose elektronische Transponder, deren Arbeitsfrequenz vorzugsweise im MHz- bis GHz-Bereich liegt, weisen meist Antennen auf, die flächig auf Substraten aus Spezialpapier oder aus Plastmaterial angebracht sind. Als Plastmaterial dient hierzu meist PVC, um eine leichte Weiterverarbeitung zu Chipkarten aus PVC zu ermöglichen. Es ist aber auch üblich Polyester (PET) und ähnliche Kunststoffe zu verwenden.

Die Kosten für die Transponder werden im wesentlichen durch die Antennenkosten und die Kosten für die Halbleiterchips bestimmt. Die Antennenkosten setzen sich aus den Materialkosten für das Antennenträgersubstrat und das Antennenmaterial und aus den Strukturierungskosten für die Antenne zusammen. Einerseits sinken die Antennenkosten drastisch je gröber die Strukturen sein dürfen und je einfacher das Antennenträgermaterial ist, andererseits sinken die Transponderkosten nur, wenn auch die Kosten für die Halbleiterchips drastisch sinken. Die Kosten der Halbleiterchips sind vorwiegend durch die aufgewendete Halbleiterfläche bestimmt. Sehr geringe Transponderkosten lassen sich nur erzielen, wenn kleinflächige Halbleiterchips auf grobstrukturierte Antennen kontaktiert werden können. Dazu ist es erforderlich, technische Vorkehrungen zu treffen, um das Halbleiterchip gleichzeitig mit dem Anfang und dem Ende einer grobstrukturierten Antenne verbinden zu können.

Für die elektrische Verbindung von Halbleiterchips mit Antennendrähten ist es bei der Herstellung von Chipkarten bekannt, die Chips in Halbleitergehäuse zu verpacken, die mit Anschlüssen versehen sind, die so lang ausgeführt sind, dass sie sowohl mit dem Anfang als auch mit dem Ende der Antenne verbunden werden können. Als nachteilig erweisen sich hierbei die hohen Kosten für die Gehäuseherstellung sowie der Raumbedarf des Gehäuses. Für die Anwendung bei Tickets, Etiketten usw. erweist sich das Gehäusevolumen als wesentlich zu groß.

Im Etikettenbereich ist es deshalb üblich, auf beiden Flächenseiten des Antennenträgers geätzte Leiterbahnen zu erzeugen. Auf der Vorderseite des Antennenträgers sind die Antennenbahnen und die Kontaktstellen für das Flip-Chip-Kontaktieren des Halbleiterchips angeordnet. Auf der Antennenträgerrückseite befindet sich ausschließlich eine kurze Leiterbahn, die vom äußeren Antennenende zu einem Kontaktstellenabschnitt des Halbleiterchips führt.

Mittels spezieller Ultraschallverfahren erfolgt ein Durchkontaktieren der Leiterbahn von der Rückseite zur Vorderseite des Antennenträgers. Diese Lösung ist mit den Nachteilen behaftet, dass die Durchkontaktierung durch den Antennenträger nur für sehr dünne Trägerfolien (1 ... 50 µm) und vorzugsweise für Aluminiumleiterbahnen geeignet ist und dass die Zuverlässigkeit der Durchkontaktierung unter mechanischer Belastung nicht gewährleistet ist. Außerdem ist ein hoher Ätzaufwand erforderlich, da das Metall der Antennenträgerrückseite bis auf die kurze Leiterbahn weggeätzt werden muss.

Es ist auch bekannt, das Halbleiterchip auf einem dünnen, kurzen, bandförmigen Folienstück, welches zwei Leiterbahnen mit jeweils inneren und äußeren Kontaktfeldern aufweist, mittels Flip-Chip-Technik oder Chip-on-Board-Technikzu kontaktieren. Danach wird der auf diese Weise entstandene Zwischenträger so auf die Antenne gelegt, dass Ende und Anfang der Antenne mit je einem äußeren Kontaktfeld zur Deckung kommen. Anschließend erfolgt das Kontaktieren mittels Ultraschall- und/oder Niederfrequenzschwingungen durch Druck- oder Lötkontaktierung. Bei diesen Verfahren ist nachteilig, dass die Kontaktierstellen unter mechanischer und längerer klimatischer Belastung nur eine geringe Zuverlässigkeit aufweisen und dass durch die Art der Verbindung das Material an der Kontaktstelle so verformt wird, dass sich die Gesamtmaterialdicke verdoppelt bzw. dass der Kontaktieraufwand unökonomisch ist.

Der Erfindung liegt die Aufgabe zugrunde, ein Verfahren und eine Anordnung der eingangs genannten Art anzugeben, mit welchen metallische Kontaktflächen von Zwischenträgern produktiv und elektrisch und mechanisch zuverlässig mit elektrisch leitenden Kontaktflächen auf Substraten kontaktiert werden können.

Erfindungsgemäß wird die Aufgabe mit einem Verfahren, welches die in Anspruch 1 angegebenen Merkmale und mit einer Vorrichtung, welche die in Anspruch 4 angegebenen Merkmale enthält, gelöst.

Vorteilhafte Weiterbildungen sind in den Unteransprüchen angegeben.

Bei dem erfindungsgemäßen Verfahren werden das zu kontaktierende, gitterförmig gestaltete äußere Kontaktfeld eines Zwischenträgers und das Kontaktfeld der Antenne und gegebenenfalls die angrenzenden Randgebiete des für Licht eines definierten Wellenlängenbereich durchsichtigen, vorzugsweise thermoplastischen Substrates des Zwischenträgers und/oder des Antennenträgers übereinanderpositioniert und mittels eines für Licht durchlässigen Pressstückes, welches auf die Substratunterseite des Kontaktfeldes des Zwischenträgers aufgesetzt wird, gegen einen Kontaktiertisch gepresst. Danach wird mit Licht, welches einen Leuchtfleckdurchmesser erzeugt, der gleich oder größer der Pressfläche des Pressstückes ist, durch das Pressstück hindurch Strahlungsenergie in die mechanisch zusammengepressten Kontaktmaterialien und Substrate bzw. Antennenträger eingetragen. Diese Energie wird im wesentlichen in den lichtundurchlässigen Kontaktmaterialien wirksam, wobei die Kontaktmaterialien so erhitzt werden, dass durch Wärmeleitung mindestens das angrenzende Substratmaterial schmilzt und sich mit dem Antennenträgermaterial und der Kontaktfläche der Antenne dauerhaft verbindet.

In einer vorteilhaften Ausführung wird als Licht monochromatisches Licht oder Laserlicht und als Substratmaterial Polyester verwendet. Die Wellenlänge des verwendeten Lichts liegt vorzugsweise im Bereich 900 ... 1100 nm.

Die Verbindung des Kontaktfeldes mit der Kontaktfläche lässt sich weiter verbessern, wenn gleichzeitig mit dem Eintrag des Lichtes Ultraschallenergie oder Niederfrequenzschwingungsenergie über das Pressstück oder über den Substrattisch in die Kontaktierzone eingebracht wird.

Ferner ist es möglich, zur Verbesserung der Verbindung des Kontaktfeldes mit der Kontaktfläche die Kontaktfläche der Antenne mit einem Flächenanteil von ≤ 25 % zu lochen oder zu schlitzen.

Durch Einfärben der Oberseite des Substratmaterials mit lichtabsorbierenden Material im Gitterbereich des Kontaktfeldes kann eine weitere Verbesserung erreicht werden. Als Material kann hierzu auch ein thermoplastischer Kleber verwendet werden, vorzugsweise ein thermoplastischer Kleber, der einen niedrigeren Erweichungspunkt als das Substratmaterial bzw. das Antennenträgermaterial aufweist. Der thermoplastische Kleber kann mit metallisch leitenden Partikeln, z. B. Silber, gefüllt sein.

Die Erfindung zeichnet sich durch eine Reihe von Vorteilen aus.
Das erfindunsgemäße Verfahren ermöglicht es, speziell gestaltete und gegebenenfalls beschichtete Zwischenträgerkontaktfelder mit Antennenkontaktflächen mittels eines kurzen Lichtimpulses mechanisch und elektrisch zuverlässig zu verbinden.
Vorteilhaft ist insbesondere, dass sich Kontaktfelder von Zwischenträgern oder zwischenträgerähnlichen Substraten so an Antennen aus Metall oder Leitpasten auf Plast, Papier o.ä. kontaktieren lassen, dass die Kontakte eine hohe mechanische und klimatische Zuverlässigkeit aufweisen, die Kontaktierung eine hohe Produktivität mit einem technologisch sicheren Verfahren ermöglicht, das Kontaktierverfahren für unterschiedlichste Antennenmaterialien eingesetzt werden kann und die Zwischenträger- und Antennenmaterialien nur gering verformt werden.

An das Antennenmaterial sollen so geringe wie möglich Anforderungen gestellt werden; der Zwischenträger jedoch soll so vorbereitet sein, dass er in der Lage ist, alle möglichen Kontaktierschwierigkeiten zu überwinden.

Durch das mit hoher Leistung auf- bzw. eingebrachte Licht werden die Kontaktmaterialien sehr stark und sehr rasch erhitzt. Das unmittelbar über oder neben den Kontaktmaterialien anliegende thermoplastische Substrat schmilzt und benetzt den Antennenträger und die Kontaktfläche der Antenne. Bedingt durch den Anpressdruck werden die Materialien zum Teil ineinander gedrückt. Die Gitterstruktur der Kontaktfelder des Substrates bewirkt, dass das Licht direkt auf die Antennenkontaktflächen gelangt und diese erhitzt, so dass das darüberliegende thermoplastische Substrat zumindestens in einer dünnen Schicht aufgeschmolzen wird, ohne dass die an dem Pressstück anliegende Substratschicht aufschmilzt. Die Metallgitter werden in die Antennenkontaktfläche teilweise eingepresst und gewährleisten insbesondere an den Gitterkanten einen sehr guten elektrischen Kontakt mit der Kontaktfläche der Antenne. Aufgrund der Gittergestaltung und der Verbindung von Substrat und Antennenträger auch um die Kontaktfelder bzw. Kontaktfläche herum, werden die Kontaktfelder und Kontaktfläche durch die umgebenden, verklebten Materialien nahezu hermetisch eingeschlossen. Die Verbindungsstelle bleibt deshalb eben.

Durch das zusätzliche Aufbringen von mechanischer Energie durch Ultraschall- oder Niederfreqenzschwingungen wird die Benetzung der Materialien durch den aufgeschmolzenen Thermoplast verbessert und die Glättung der Kontaktstelle beschleunigt.

Durch Lochen oder Schlitzen der Kontaktfläche der Antenne mit relativ kleinen Löchern bzw. schmalen Schlitzen ergeben sich weitere Vorteile:
Neben der allgemeinen Erhöhung der mechanischen Festigkeit der Verbindungszone wird erreicht, dass das schmelzflüssige Substratmaterial bzw. der verflüssigte Schmelzkleber über die Fläche der Kontaktfläche verteilt an vielen Stellen den Antennenträger benetzt.
Außerdem wird das Kontaktfeldgitter des Substratfeldes zum Teil auch über die Kanten der Löcher und Schlitze der Kontaktfläche gepresst und die Anzahl der Kontaktkantenpressungen erhöht sich.

Durch Einfärben der Oberseite des Substratmaterials kann die Lichtabsorption der kontaktfeldtragenden Substratoberseite und damit die Schmelzverflüssigung der in der Verbindungszone innenliegenden Substratschicht erleichtert werden. Das Einfärben selbst kann in einfacher Weise durch Bestäuben (z.B. mit Graphitstaub), Bedrucken (z.B. mit Tintenstrahltechnik) o.ä. erfolgen.

Eine weitere bedeutende Verbesserung kann dadurch erreicht werden, dass eine dünne Schicht eines thermoplastischen, lichtabsorbierenden Klebers im Bereich des Substratkontaktfeldes (Gitters) aufgetragen wird. Die Verbesserung wird insbesondere dann signifikant sein, wenn der thermoplastische Kleber einen tieferen Erweichungspunkt aufweist als das Substrat- und Antennenmaterial und wenn der thermoplastische Kleber in schmelzflüssigen Zustand Substrat, Kontaktmaterial und Antennenträger sehr gut benetzt und im erkalteten Zustand eine hohe Adhäsion zu den genannten Materialien aufweist. Werden thermoplastische Kleber eingesetzt, die auch duroplastisches Material sehr gut benetzen, können als Substratmaterialien auch lichtdurchlässige Duroplaste verwendet werden.

Eine weitere Verbesserung wird erreicht, wenn der thermoplastische Kleber mit lichtabsorbierenden, elektrisch leitenden Partikeln gefüllt ist.

Durch Verwendung von Licht nur eines bestimmten Wellenlängenbereiches als Energiequelle und von Pressstücken und Substraten geringer Lichtabsorption sowie von Kontaktmaterialien und eingebrachten Farb- oder Schmelzkleberschichten, die eine hohe Lichtabsorption aufweisen, ergibt sich der Vorteil, dass die kontaktbildenden Prozesse nur im Inneren der Verbindungszone stattfinden und die Substratunterseite und Antennenträgerunterseite nicht aufschmelzen und Pressfläche sowie Kontaktiertisch nicht verschmutzen.

Durch Laserlicht, insbesondere durch Diodenlaser, kann vorteilhaft und mit einfachem apparatetechnischen Aufwand die erforderliche Lichtenergie in die Verbindungszone eingebracht werden.

Die Verwendung von Polyestermaterialien als Substratmaterial des Zwischenträgers, die sich durch hervorragende mechanische, chemische, thermische und elektroisolierende Eigenschaften auszeichnen und kostengünstig sind, wird eine gut aufschmelzbare und durch mechanische Schwingungen (Ultraschall; Niederfrequenz) verformbare Verbindungsstelle geschaffen.

Die Erfindung wird im Folgenden anhand eines Ausführungsbeispiels näher erläutert. In der zugehörigen Zeichnung zeigen:
- Figur 1: einen Zwischenträger in Draufsicht,
- Figur 2: die Seitenansicht eines Zwischenträgers in Schnittdarstellung,
- Figur 3: die Kontaktfläche einer Antenne in Draufsicht,
- Figur 4: die Seitenansicht der Verbindungszone des Zwischenträgers am Antennenträger unmittelbar vor dem Kontaktieren in Schnittdarstellung und
- Figur 5: die Seitenansicht der Kontaktstelle während dem bzw. nach dem Kontaktieren in Schnittdarstellung.

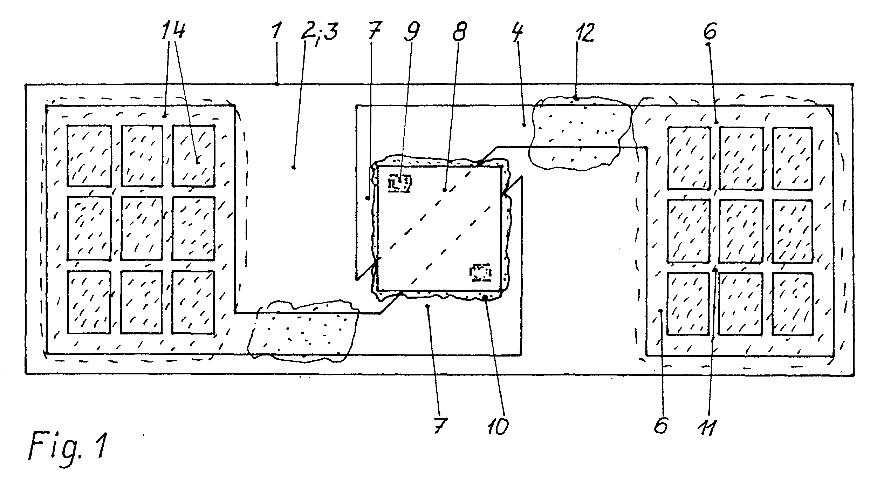

Der Zwischenträger 1 in Figur 1 trägt in seiner Mitte ein flipgebondetes Chip 8 mit zwei Kontakthügeln 9, die auf den inneren Kontaktfeldern 7 aufliegen. Das Chip 8 ist mittels thermisch ausgehärtetem Underfiller 10 fest auf den inneren Kontaktfeldern 7 und der Oberseite 3 des im Beispiel 50 µm dicken Polyestersubstrates 2 fixiert. Von den inneren Kontaktfeldern 7 zu den äußeren Kontaktfeldern 6 verlaufen Leiterbahnen 4, die ebenfalls mittels im Beispiel elektrisch isolierendem, thermisch ausgehärteten Underfiller beschichtet sind. Innere und äußere Kontaktfelder 7; 8 und Leiterbahnen 4 bestehen aus 35 µm dickem Aluminium, das nasschemisch strukturiert wurde.

Die äußeren Kontaktfelder 6 weisen eine Gitterstruktur 11 auf, wobei die Stege ca. (100 ... 200) µm breit sind und die Gitterlöcher ca. (400 x 400) µm² bis (600 x 600) µm² groß sind. Die äußeren Kontaktfelder 6, insbesondere aber die Gitterzwischenräume und die Kontaktfeldperipherie sind mit einem für die verwendete Lichtwellenlänge λ = 940 nm stark energieabsorbierenden thermoplastischen Kleber 14, der im Beispiel einen mindestens 30° C niedrigen Erweichungspunkt aufweist als das Polyestersubstrat 2, beschichtet. Die Beschichtungsdicke entspricht etwa der Dicke des Kontaktfeldmaterials.

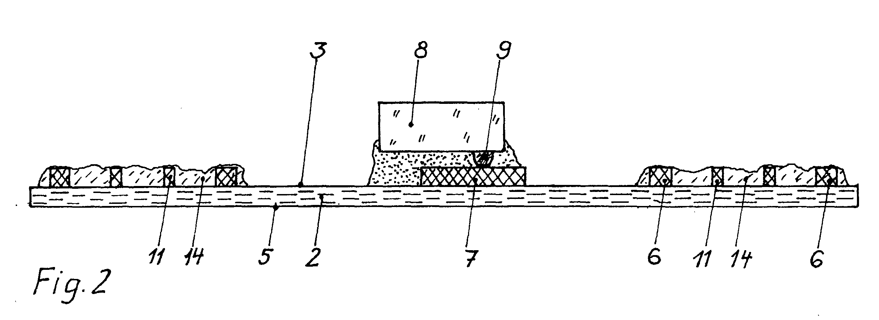

Figur 2 zeigt den Zwischenträger 1 in seitlicher Ansicht, wobei der Schnitt durch einen Kontakthügel 9 geführt wurde. Die Gitterlöcher 11 der äußeren Kontaktfelder 6 sind mit lichtabsorbierendem Kleber 14 gefüllt.

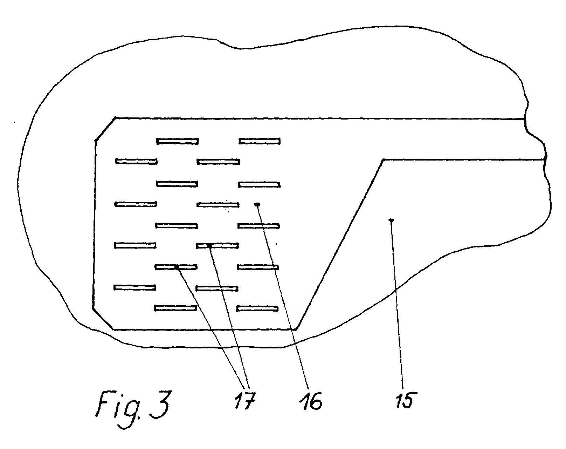

Die Größe der Antennenkontaktfläche 16 in Figur 3 ist annähernd den äußeren Kontaktfeldern 6 des Zwischenträgers 1 gleich.

Das Kontaktmaterial besteht im Beispiel aus 20 µm dickem Aluminium, welches sich auf 30 µm dickem Polyester als Antennenträger 15 befindet.
Die Antennenkontaktfläche 16 ist geschlitzt; die Schlitzstruktur 17 wurde im Beispiel durch Laserschnitt erzeugt. Die Schlitzbreite ist kleiner gleich 100 µm; die Schlitzlänge beträgt (300 ... 500) µm.

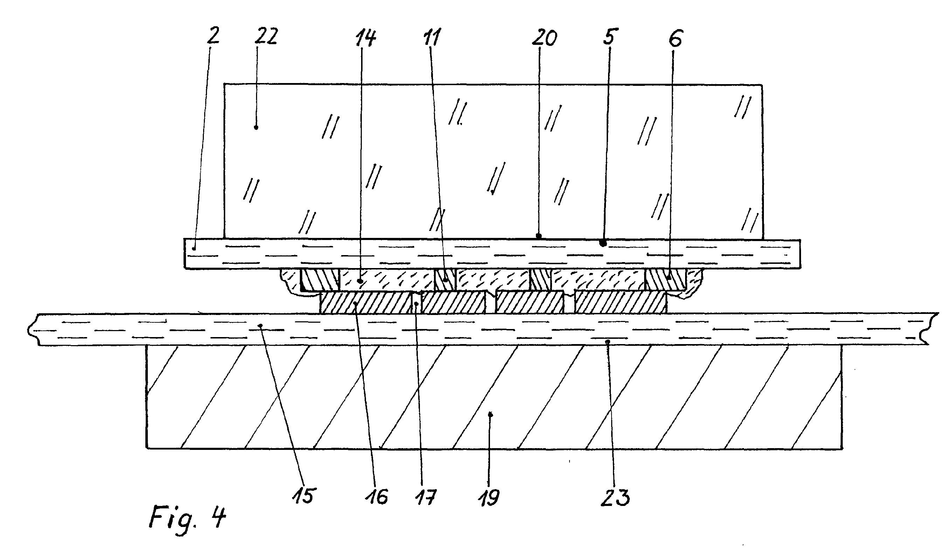

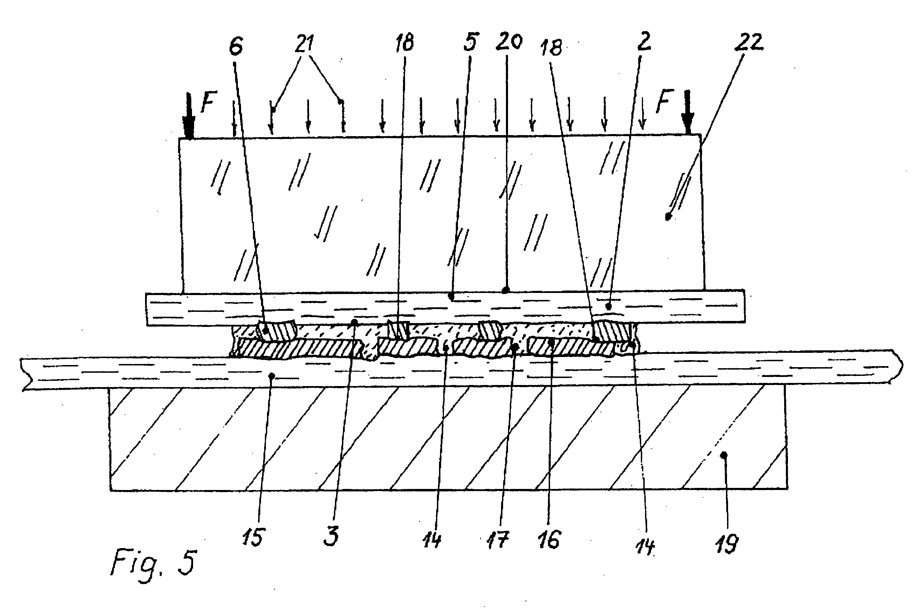

In Figur 4 liegt das Antennenträgermaterial 15 mit seiner Unterseite 23 auf dem Kontaktiertisch 19 auf. Auf der Antennenkontaktfläche 16, die im Beispiel (2,5 x 2,5) mm² groß ist, liegt das äußere Kontaktfeld 6 des Zwischenträgers 1 auf und überdeckt die Antennenkontaktfläche 16 vollständig. Das äußere Kontaktfeld 6 und die Antennenkontaktfläche 16 berühren sich flächig in der künftigen Verbindungszone 18 Figur 5. Die Substratunterseite 5 des Zwischenträgers 1 weist nach oben, auf sie presst mit der Kraft F die Pressfläche 20 des insgesamt für die Laserlichtwellenlänge von λ = 940 nm nahezu vollständig durchlässigen Pressstückes 22.

Den Zustand der Verbindungszone 18 zum Schluss der Laserbestrahlung, wobei die durch den Laserstrahl 21 belichtete Fläche gleich oder größer der Antennenkontaktfläche 16 ist, zeigt Figur 5. Der thermoplastische Kleber 14 wurde nahezu vollständig aufgeschmolzen. Entsprechend den Druckverhältnissen verteilt er sich zwischen Antennenträger 15 und Substratoberseite 3 und benetzt sowohl das Antennenträgermaterial 15 als auch die Antennenkontaktfläche 16 sowie die Schlitzwandungen 17. Die ebenfalls durch den Laserstrahl 21 aufgeheizten Aluminiumstrukturen 6; 16 wurden durch den Pressdruck etwas in des Substrat 2 bzw. das Antennenträgermaterial 15 eingedrückt. Gleichzeitig wurden die Aluminiumstrukturen 6; 16 so zusammengedrückt, dass sowohl Flächen- als auch Kantenkontakte auftreten. Insgesamt hermetisiert der thermoplastische Kleber 14 die Verbindungszone 18. Kontaktiertisch 19 und Pressstück 22 sind nicht beheizt; sie kühlen die außenliegenden Flächen der Anordnung.

### BEZUGSZEICHENLISTE

- 1: Zwischenträger
- 2: Substrat
- 3: Substratoberseite
- 4: Leiterbahn
- 5: Subtratunterseite
- 6: äußeres Kontaktfeld
- 7: inneres Kontaktfeld
- 8: Halbleiterchip
- 9: Kontakthügel
- 10: Underfiller
- 11: Gitterstruktur des äußeren Kontaktfeldes
- 12: Leiterbahnisolierung mit Underfiller
- 13: Absorptionsschicht
- 14: Absorptionsmaterial; Schmelzkleber; thermoplastischer Kleber
- 15: Antennenträgermaterial
- 16: Antennenkontaktfläche
- 17: Lochstruktur der Antennenkontaktfläche bzw. Schlitzstruktur
- 18: Verbindungszone
- 19: Kontaktiertisch
- 20: Pressfläche
- 21: Laserstrahl
- 22: Pressstück
- 23: Antennenträgerunterseite

## Patentansprüche

1. Verfahren zum Kontaktieren von auf Substratfolien (2) angeordneten metallischen Kontaktfeldern (6) mit elektrisch leitenden Kontaktflächen (16), die sich auf einem Substrat aus Plaste, Papier, Pappe oder ähnlichen befinden, **dadurch gekennzeichnet, dass** die Kontaktfelder (6) eine Gitterstruktur (11) aufweisen, die zu kontaktierenden Bereiche übereinander positioniert und mit einem lichtdurchlässigen Pressstück (22) zusammengedrückt werden, und die zu kontaktierenden Bereiche mit Licht hoher Intensität eines Wellenlängenbereiches, für den das Pressstück (22) und die thermoplastische Substratfolie (2) durchlässig aber die Kontaktfelder (6) und Kontaktflächen (16) stark energieabsorbierend sind, so bestrahlt wird, dass die bestrahlten Kontaktmaterialien (6; 16) erhitzt werden und dadurch das anliegende und/oder angepresste Substrat (2) in der Verbindungszone (18) aufschmilzt und Flächenteile der Kontaktoberflächen (6; 16) sowie das umliegende Trägermaterial (2; 15) benetzt und nach Beenden der Bestrahlung das aufgeschmolzene Material (2) erstarrt und sich dabei eine dauerhafte mechanische und elektrische Verbindung zwischen den Kontaktmaterialien (6; 16) und den Trägermaterialien (2; 15) ergibt.

2. Verfahren nach Anspruch 1, **dadurch gekennzeichnet, dass** die Bestrahlung mit monochromatischem oder nahezu monochromatischem Licht im Wellenlängenbereich 900 ... 1100 nm erfolgt.

3. Verfahren nach Anspruch 1 oder 2, **dadurch gekennzeichnet, dass** gleichzeitig mit der Lichtbestrahlung über das Pressstück (22) oder einen Kontaktiertisch (19) in die Verbindungszone Ultraschall- oder Niederfrequenzschallenergie eingetragen wird.

4. Verfahren nach einem der vorhergehenden Ansprüche, **dadurch gekennzeichnet, dass** auf das gitterstrukturierte Kontaktfeld (6; 11) lichtabsorbierender Schmelzkleber (14) aufgebracht ist.

5. Verfahren nach Anspruch 4, **dadurch gekennzeichnet, dass** der Schmelzkleber (14) mit lichtabsorbierenden elektrisch leitfähigen Partikeln versehen ist.

6. Anordnung, insbesondere zur Durchführung des Verfahrens nach einem der Ansprüche 1 bis 5, **dadurch gekennzeichnet, dass** auf einem Zwischenträger (1) mindestens zwei äußere Kontaktfelder (6) mit nach innen verlaufenden Leiterbahnen (4) angeordnet sind, wobei auf den äußeren Kontaktfeldern (6) lichtabsorbierendes Material (14) aufgebracht ist, welches einen niedrigeren Erweichungspunkt aufweist als das Material des Zwischenträgers (1) und dass der Zwischenträger (1) mit einem Antennenträgermaterial (15) kontaktiert ist, welcher mit einer Antennenkontaktfläche (16) versehen ist, so dass sich jeweils ein äußeres Kontaktfeld (6) und eine Antennenkontaktfläche (16) zumindest partiell flächig in einer künftigen Verbindungszone (18) berühren.

7. Anordnung nach Anspruch 6, **dadurch gekennzeichnet, dass** die äußeren Kontaktfelder (6) eine Gitterstruktur (11) aufweisen.

8. Anordnung nach Anspruch 6 oder 7, **dadurch gekennzeichnet, dass** der Zwischenträger (1) auf einem Polyestersubstrat (2) aufbaut.

9. Anordnung nach einem der Ansprüche 5 bis 7, **dadurch gekennzeichnet, dass** der Zwischenträger (1) ein flipgebondetes Chip (8) trägt, welches mittels thermisch ausgehärtetem Underfiller (10) auf inneren Kontaktfeldern 7 befestigt ist.

10. Anordnung nach einem der Ansprüche 6 bis 9, **dadurch gekennzeichnet, dass** die Kontaktfläche (16) der Antenne Schlitze oder Löcher (17) aufweist.

11. Anordnung nach einem der Ansprüche 5 bis 9, **dadurch gekennzeichnet, dass** die Oberseite (3) des Substratmaterials (2) im Bereich der äußeren Kontaktfelder (6) mit lichtabsorbierendem Material beschichtet ist.

12. Anordnung nach einem der Ansprüche 6 bis 11, **dadurch gekennzeichnet, dass** das lichtabsorbierende Material ein thermoplastischer Kleber (14) ist.

13. Anordnung nach Anspruch 12, **dadurch gekennzeichnet, dass** die Substratfolie (2) aus thermoplastischem Material besteht.

14. Anordnung nach Anspruch 12, **dadurch gekennzeichnet, dass** der thermoplastische Kleber (14) auf einem Duroplastmaterial aufgetragen ist und dass das Substrat (2) des Zwischenträgers (1) aus lichtdurchlässiger duroplastischer Folie (2) besteht.
